# FASCICULE DE BREVET EUROPEEN

(11) **EP 2 591 137 B1**
(45) Date de publication et mention de la délivrance du brevet: **09.01.2019**
(21) Numéro de dépôt: 11741649.5
(22) Date de dépôt: 08.07.2011
(51) Int. Cl.: C23C 10/06, C23C 10/14, C23C 10/34, C23C 10/50, C23C 10/52, C23C 16/08

(54) **PROCÉDÉ POUR FORMER UN REVÊTEMENT PROTECTEUR À LA SURFACE D'UNE PIÈCE MÉTALLIQUE**
VERFAHREN ZUR BILDUNG EINER SCHUTZBESCHICHTUNG AUF DER OBERFLÄCHE EINES METALLTEILS
PROCESS FOR FORMING A PROTECTIVE COATING ON THE SURFACE OF A METAL PART

(30) Priorité: 09.07.2010 FR 1055633
(43) Date de publication de la demande: 15.05.2013
(73) Titulaire: Safran Aircraft Engines, 75015 Paris (FR)
(72) Inventeur: MENUEY, Justine, F-79120 Lezay (FR); MALIE, André, Hubert, Louis, F-86100 Chatellerault (FR)
(74) Mandataire: Gevers & Orès
(86) Numéro de dépôt international: PCT/FR2011/051638
(87) Numéro de publication internationale: WO 2012/004548

(56) Documents cités:
- EP-A2- 1 466 996
- WO-A1-2009/112581
- KIPKEMOI J ET AL: "Rare-earth modified chromium-aluminide coatings applied by pack cementation method on low-alloy steels", JOURNAL OF MATERIALS SCIENCE CHAPMAN & HALL UK, vol. 31, no. 23, 1 décembre 1996 (1996-12-01), pages 6247-6250, XP002615709, ISSN: 0022-2461

## Description

La présente invention concerne le dépôt d'un revêtement protecteur à base d'aluminium sur une pièce métallique. Elle vise plus particulièrement l'application d'un tel revêtement sur des pièces de turbomachine, notamment de moteur à turbine à gaz.

Un moteur à turbine à gaz, tel qu'utilisé pour la propulsion dans le domaine aéronautique comprend une entrée d'air atmosphérique qui communique avec un ou plusieurs compresseurs, dont une soufflante généralement, entraînés en rotation autour d'un même axe. Le flux primaire de cet air après avoir été comprimé alimente une chambre de combustion disposée annulairement autour de cet axe et est mélangé à un carburant pour fournir des gaz chauds en aval à une ou plusieurs turbines à travers lesquelles ceux-ci sont détendus, les rotors de turbine entraînant les rotors de compression. Les moteurs fonctionnent à une température des gaz moteurs en entrée de turbine que l'on cherche aussi élevée que possible car les performances lui sont liées. Dans ce but les matériaux sont sélectionnés pour résister à ces conditions de fonctionnement et les parois des pièces balayées par les gaz chauds, telles que les distributeurs ou les ailettes mobiles de turbine, sont pourvues de moyens de refroidissement. Par ailleurs, en raison de leur constitution métallique en superalliage à base de nickel ou de cobalt, il est nécessaire aussi de prémunir celles-ci de l'érosion et de la corrosion engendrées par les constituants des gaz moteurs à ces températures.

Un moyen connu pour assurer la protection de ces pièces est de déposer un revêtement à base d'aluminium sur les surfaces susceptibles d'agression par les gaz. L'aluminium se fixe au substrat par inter-diffusion métallique et forme une couche protectrice d'oxyde en surface. On distingue la couche additionnelle de la couche diffusée. L'épaisseur du revêtement est de l'ordre de quelques dizaines de microns.

La présente invention se rapporte à la technique, en soi connue, de dépôt de l'aluminium en phase vapeur ou encore désignée aluminisation par dépôt en phase vapeur. Selon le procédé, on dispose les pièces à traiter dans une enceinte semi étanche dans laquelle l'atmosphère est constituée d'un mélange d'un gaz inerte ou réducteur, par exemple argon ou hydrogène, et d'un gaz actif comprenant un halogénure d'aluminium. A la température de réaction, entre 900°C et 1150°C, l'halogénure se décompose à la surface de la pièce en halogène gazeux et en aluminium qui diffuse dans le métal.

On produit l'halogénure en disposant dans l'enceinte avec les pièces à traiter, un cément donneur d'aluminium métallique ou d'alliage métallique d'aluminium avec un ou plusieurs des constituants métalliques, notamment le chrome, du matériau formant les pièces à protéger, en présence de granules d'un composé d'halogène, chlore ou fluor, qui forment l'activateur. On fait circuler le gaz inerte sur l'activateur à une température permettant la sublimation de l'halogène qui est entraîné sur le donneur et avec lequel il réagit pour produire l'halogénure métallique qui, à cette température, est sous forme vapeur.

L'activateur devant être gazeux à la température du revêtement et ne pas produire de polluants, on choisit généralement des produits tels que le chlorure d'ammonium, le fluorure d'ammonium ou le bifluorure d'ammonium. En présence d'hydrogène ou sous gaz neutre et à température élevée, ces molécules se décomposent en ammoniac et en halogène. La température de vaporisation dépend de la nature du sel halogéné choisi. Par exemple, elle est de 340°C pour le chlorure d'ammonium. L'activateur n'est utilisé que pour transporter en toute sécurité un acide halogéné dans le réacteur où le dépôt doit être effectué, c'est à dire la boîte semi-étanche. Le cation lié à cet halogène (ici l'ammonium) est par voie de conséquence inutile.

L'halogénure se décompose ensuite au contact du substrat métallique à revêtir permettant le dépôt de l'aluminium. Au cours de l'aluminisation, il s'instaure un processus cyclique de dépôt d'aluminium se poursuivant continuellement jusqu'à ce que l'activité en aluminium de la surface du substrat devienne égale à celle imposée par le cément. L'halogène gazeux est reformé. Le revêtement obtenu sert éventuellement de couche intermédiaire entre le substrat métallique et une barrière de protection thermique de ce substrat sur lequel on vient l'appliquer. Le revêtement permet d'améliorer aussi bien la tenue de la barrière thermique sur le substrat que la capacité de ce dernier à conserver des caractéristiques d'usage en cas de dégradation de la barrière thermique.

Par ailleurs, on connaît l'effet favorable du zirconium sur l'adhérence d'une couche d'oxyde sur un substrat métallique, que cette couche soit formée par exposition à l'air à haute température ou par dépôt d'une barrière thermique.

Dans le brevet FR 2 853 329, on décrit un procédé d'aluminisation en phase vapeur modifié de manière à permettre la co-déposition de l'aluminium et du zirconium. L'halogénure d'ammonium du procédé APVS classique est remplacé au moins en partie par un composé de zirconium dont on souhaite voir la présence dans le dépôt à l'état de traces.

Parmi les sels de zirconium susceptibles de jouer le rôle d'un activateur, sont cités non limitativement, le chlorure de zirconium ZrCl4, l'oxychlorure de zirconium ZrOCl2 et le fluozirconate d'ammonium (NH4)2ZrF6. Tous ces sels sont gazeux au-delà de 250°C. L'oxychlorure de zirconium est l'activateur préféré.

Le principe du dépôt reste identique à celui du procédé APVS. On dispose le cément à base d'aluminium ou d'alliage d'aluminium et notamment de chrome, sous forme de grains dans une boîte semi-étanche appropriée. Les pièces à revêtir sont disposées de façon à être mises en contact avec l'halogénure d'aluminium gazeux formé. L'activateur halogénure d'ammonium est remplacé en tout ou en partie par de l'oxychlorure de zirconium. On chauffe l'enceinte dans laquelle la boîte est placée jusqu'à la température du traitement APVS. Au delà d'une certaine température, l'activateur s'évapore et forme une vapeur riche en chlorure de zirconium. Ce dernier se décompose à la surface du substrat en superalliage de nickel pour former du zirconium à l'état métallique d'une part et un acide halogéné disponible pour former dans le cément donneur un halogénure d'aluminium d'autre part. Le zirconium déposé à la surface du substrat diffuse ensuite dans le revêtement de bêta -NiAl en cours de formation pour donner un intermétallique enrichi entre 500 et 1000 ppm (parties par million) de zirconium.

La présente demanderesse a cherché à améliorer le procédé d'aluminisation par dépôt en phase vapeur de ce type avec codéposition de zirconium, dans le but de piloter la concentration en Zr dans le dépôt. Un procédé mettant en oeuvre cette technique est décrit dans la demande de brevet publiée sous le numéro WO 2009/112581 au nom de Snecma.

Le procédé décrit dans cette demande de brevet comprend la mise en contact de la pièce et d'un cément en alliage d'aluminium, à une température de traitement, avec une atmosphère contenant un gaz activateur qui, d'une part réagit avec le cément pour former un halogénure d'aluminium gazeux, lequel se décompose au contact de la pièce en y déposant de l'aluminium métallique, d'autre part contient ZrOCl₂ qui se décompose au contact de la pièce en y déposant le métal Zirconium, et est formé par vaporisation de granules de ZrOCl₂ solide à température ambiante. Selon ce procédé, on chauffe progressivement et ensemble la pièce, le cément et les granules de ZrOCl₂ dans une enceinte depuis la température ambiante jusqu'à la température de traitement avec un palier à 400°C +/- 200°C plus particulièrement à 500°C +/- 100°C.

Pour ce cycle, la durée du palier de chauffage est 5 à 30 minutes, avec une vitesse de montée en température comprise entre 4 et 20°C par minute.

On maîtrise de cette façon la quantité de zirconium déposé, le palier permettant d'une part une bonne homogénéisation de l'atmosphère en zirconium avec des réactions chimiques complètes, d'autre part la montée rapide en température après la décomposition permettant le dépôt simultané d'aluminium et de zirconium.

La pièce contient au moins du nickel qui se combine avec l'aluminium pour former dans le revêtement un composé intermétallique NiAl dans lequel l'aluminium est partiellement substitué par le zirconium. Plus particulièrement, la pièce est en superalliage à base de nickel.

Ce procédé est bien adapté au cas où l'on forme une sous-couche aluminisée d'une barrière thermique telle que celle formée selon la technique présentée par exemple dans le brevet EP 1 473 378.

Le zirconium dans cette sous-couche permet de stabiliser la migration de l'aluminium en agissant comme modérateur à la diffusion de l'aluminium. En effet, celui-ci a tendance à migrer de la sous-couche dans le substrat avec pour conséquence la fragilisation de la sous-couche due aux manques de matière dans la sous couche qui en résulte. Par ailleurs l'aluminium dans la barrière thermique forme de l'alumine qui fragilise l'adhérence de la barrière thermique à la sous couche.

La présente invention vise encore à améliorer le procédé ci-dessus car pour avoir un bonne tenue en durée de vie le zirconium devrait être localisé ponctuellement dans la sous-couche d'aluminure

Le procédé précédemment décrit dans la demande de brevet permet le dépôt de zirconium dans toute la couche avec un pic de concentration mais ce pic reste localisé dans la couche additionnelle. En outre le procédé du brevet FR 2 853 329, également précédemment cité, n'apporte pas un enseignement qui s'appliquerait à une installation industrielle.

Conformément à l'invention, le procédé pour former sur la surface d'une pièce métallique un revêtement protecteur contenant de l'aluminium et du zirconium, selon lequel
on met en contact ladite pièce et un cément en alliage d'aluminium avec un gaz à une température de traitement dans une enceinte de traitement,
le gaz comprenant un gaz porteur et un activateur,
l'activateur réagissant avec le cément pour former un halogénure d'aluminium gazeux, qui se décompose à la surface de la pièce en y déposant de l'aluminium métallique,
l'activateur contenant un sel de zirconium, tel que ZrOCl₂, obtenu à partir de granules de sel de zirconium, les réactions de dissociation dudit sel de zirconium se produisant dans un intervalle de température de dissociation avec formation d'un dépôt de métal Zr à la surface de la pièce,
on chauffe progressivement ensemble la pièce, le cément et les granules de sel de zirconium dans l'enceinte depuis la température ambiante jusqu'à la température de traitement,
est caractérisé par le fait que l'enceinte de traitement est maintenue en surpression sans circulation de gaz porteur pendant l'intervalle de température correspondant aux réactions de dissociation du sel de zirconium.

Le procédé de l'invention permet ainsi en jouant sur les réactions chimiques se produisant aux différents stades du traitement thermique de garantir le dépôt de zirconium à l'interface couche diffusée - couche additionnelle. Plus précisément on définit les températures et les gaz porteurs appropriés pour obtenir le résultat souhaité.

Le procédé de l'invention comprend éventuellement les caractéristiques suivantes, prises seules ou en combinaison :
La montée en température comprend un palier compris entre 200°C et 700°C, notamment entre 300°C et 600°C. Cet intervalle correspond aux températures de réactions de dissociation de l'activateur.
La durée du palier de chauffage est de 5 à 30 minutes.

La boîte de traitement formant l'enceinte est semi étanche. La surpression est légèrement supérieure à la pression atmosphérique et permet aux gaz de transition de ne pas être chassés de la zone de réaction.

On met en circulation le gaz porteur à travers l'enceinte après que la température de l'enceinte a dépassé ledit intervalle de température.

On chauffe progressivement à une vitesse de montée en température comprise entre 4 et 20°C par minute.

Ledit activateur contient en outre au moins un halogénure d'ammonium.

Le gaz porteur est un gaz réducteur, tel que H2, ou neutre, tel que l'argon.

La pièce contient au moins du nickel qui se combine avec l'aluminium pour former dans le revêtement un composé intermétallique NiAl dans lequel l'aluminium est partiellement substitué par le zirconium.

La pièce est en superalliage à base de nickel.

L'élément zirconium est remplacé au moins en partie par le hafnium ou l'yttrium.

L'alliage d'aluminium comprend du chrome.

Ladite température de traitement est comprise entre 950 et 1200°C et de préférence d'environ 1100°C.

D'autres caractéristiques et avantages ressortiront de la description qui suit en se référant aux figures annexées.

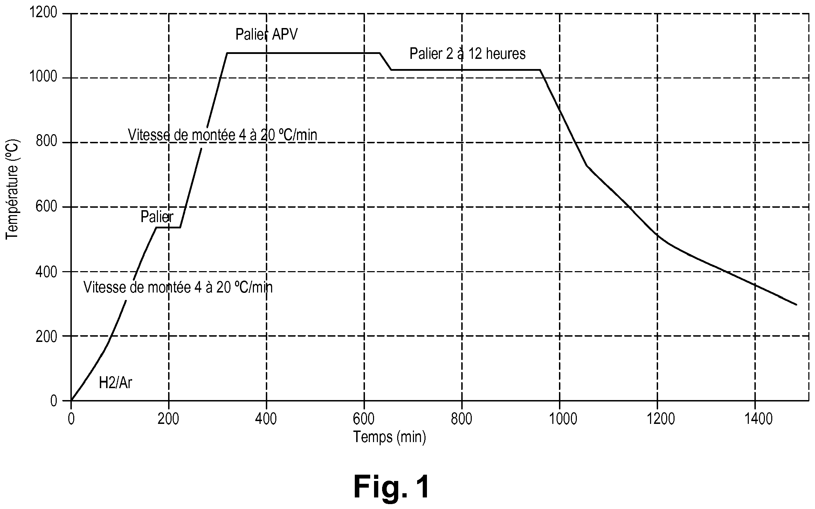

La figure 1 est un graphique représentant l'évolution en température d'un procédé selon l'invention.
La figure 2 est un graphique représentant un exemple d'évolution du taux de zirconium depuis la surface, en fonction de l'épaisseur de la couche aluminisée.

Comme cela a été rapporté plus haut, le procédé s'applique avantageusement au traitement des aubes mobiles de turbine ou aux ailettes de distributeur.

On dispose, avec les pièces à traiter, un cément donneur d'aluminium constitué d'un alliage chrome-aluminium dans une boîte semi étanche, elle-même placée dans une enceinte fermée de manière à pouvoir travailler sous atmosphère contrôlée. On a utilisé un cément à 30% d'aluminium. D'autres teneurs en aluminium permettent l'obtention de revêtements de différentes structures et de différentes épaisseurs.

On place également de l'oxychlorure de zirconium formant l'activateur, qui est solide à température ambiante, en proportion par rapport au cément de quelques pour_cent.

L'enceinte est ensuite purgée avant introduction du gaz porteur constituant l'atmosphère initiale, argon ou l'hydrogène.

Le cycle de traitement comprend, comme on peut le voir sur le graphique annexé, une première étape de chauffage. La montée en température est progressive. La vitesse de montée en température est comprise entre 4 et 20°C par minute. Lorsque la température atteint entre 300 et 600°C, on maintient celle-ci constante pendant une durée comprise entre 5 et 30 minutes de manière à assurer la vaporisation des granulés d'oxychlorure de zirconium. La montée en température après la décomposition est déterminée de manière à assurer le dépôt de zirconium avec celui de l'aluminium.

Pendant cette phase du cycle, on maintient la pression à l'intérieur de l'enceinte à une valeur légèrement supérieure à la pression atmosphérique. Le maintien de la pression permet ici de ne pas laisser les gaz de transition que sont Zr₂O₃Cl₂ et ZrCl₄ être chassés de la boîte de traitement, car les concentrations sont assez faibles.

Ces gaz sont venus des réactions suivantes

2 ZrOCl₂ + H₂O -> Zr₂O₃Cl₂ + 2HCl (g)

Zr₂O₃Cl₂ -> 1/2ZrCl₄ (g) + 3/2ZrO₂

ZrCl₄ = 2H₂ (g) -> Zr (s) + 4HCl

Une fois l'activateur dissocié et déposé, l'atmosphère est modifiée et le reste du traitement est réalisé avec un flux de gaz porteur traversant l'enceinte ; le débit est compris avantageusement entre 5 et 30 l/min ; la pression restant à la pression atmosphérique ou légèrement supérieure à celle-ci.

Lorsque l'enceinte a atteint la température de traitement d'aluminisation, comprise entre 1080°C et 1180°C, on maintient celle-ci pendant 4 à 16 heures de façon à permettre le dépôt de l'aluminium et sa diffusion dans la pièce.

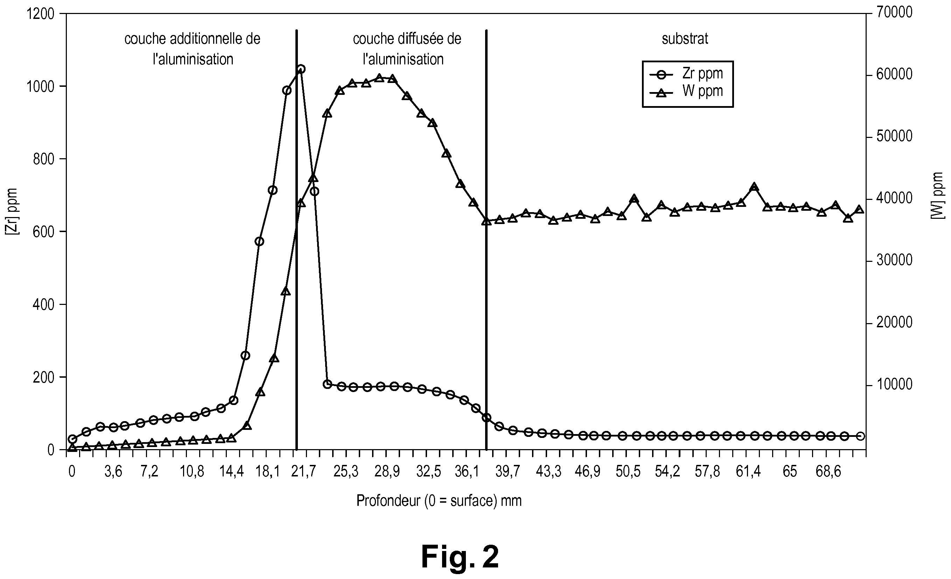

On a représenté sur la figure 2 un exemple de concentrations de Zr, données en ppm, en fonction de l'épaisseur, donnée en µm, depuis la surface de la pièce traitée conformément à l'invention. L'évolution du taux est fonction de paramètres tels que l'atmosphère, la température de palier, et de la vitesse de montée en température. On observe bien un pic de concentration en zirconium dans la zone frontière entre la couche additionnelle et la couche diffusée qui, ici, se caractérise par un accroissement de tungstène.

## Revendications

1. Procédé pour former sur la surface d'une pièce métallique un revêtement protecteur contenant de l'aluminium et du zirconium, selon lequel
on met en contact ladite pièce et un cément en alliage d'aluminium avec un gaz à une température de traitement dans une enceinte de traitement,
le gaz comprenant un gaz porteur et un activateur,
l'activateur réagissant avec le cément pour former un halogénure d'aluminium gazeux, qui se décompose à la surface de la pièce en y déposant de l'aluminium métallique,
l'activateur contenant un sel de zirconium, tel que ZrOCl₂, obtenu à partir de granules de sel de zirconium, les réactions de dissociation dudit sel de zirconium se produisant dans un intervalle de température de dissociation avec formation d'un dépôt de métal Zr à la surface de la pièce,
on chauffe progressivement ensemble la pièce, le cément et les granules de sel de zirconium dans l'enceinte depuis la température ambiante jusqu'à la température de traitement, **caractérisé par le fait que** l'enceinte de traitement est maintenue en surpression sans circulation de gaz porteur pendant l'intervalle de température correspondant aux réactions de dissociation du sel de zirconium.

2. Procédé, selon la revendication 1, dont la montée en température comprend un palier compris entre 200°C et 700°C, plus particulièrement entre 300°C et 600°C.

3. Procédé, selon la revendication 2, dans lequel la durée du palier de chauffage est de 5 à 30 minutes.

4. Procédé selon l'une des revendications précédentes, dans lequel on met en circulation le gaz porteur à travers l'enceinte après que la température de l'enceinte a dépassé ledit intervalle de température.

5. Procédé, selon l'une des revendications précédentes, dans lequel on chauffe progressivement à une vitesse de montée en température comprise entre 4 et 20°C par minute.

6. Procédé, selon l'une des revendications précédentes, dans lequel ledit activateur contient en outre au moins un halogénure d'ammonium.

7. Procédé, selon l'une des revendications précédentes, dont le gaz porteur est un gaz réducteur, tel que H2, ou neutre, tel que l'argon.

8. Procédé, selon la revendication précédente, dans lequel la pièce est en superalliage à base de nickel.

9. Procédé, selon l'une des revendications précédentes, dans lequel l'élément zirconium est remplacé au moins en partie par le hafnium ou l'yttrium.

10. Procédé selon l'une des revendications précédentes, dans lequel ladite température de traitement est comprise entre 950 et 1200°C et de préférence d'environ 1100°C.

## Patentansprüche

1. Verfahren zum Bilden einer Aluminium und Zirconium enthaltenden Schutzbeschichtung auf der Oberfläche eines Metallteils, wobei
man das Teil und einen Zement aus Aluminiumlegierung mit einem Gas bei einer Behandlungstemperatur in einer Behandlungskammer in Kontakt bringt,
das Gas ein Trägergas und einen Aktivator umfasst,
der Aktivator mit dem Zement reagiert, um ein gasförmiges Aluminiumhalogenid zu bilden, das sich auf der Oberfläche des Teils zersetzt und metallisches Aluminium darauf abscheidet,
der Aktivator ein ausgehend von Zirconiumsalz-Granulat erhaltenes Zirconiumsalz wie ZrOCl₂ enthält, wobei die Reaktionen zur Dissoziation des Zirconiumsalzes in einem Dissoziationstemperaturintervall mit der Bildung einer Zr-Metallabscheidung an der Oberfläche des Teils auftreten,
das Teil, der Zement und das Zirconiumsalz-Granulat in der Kammer ab der Umgebungstemperatur bis zu der Behandlungstemperatur schrittweise erwärmt werden, **dadurch gekennzeichnet, dass** die Behandlungskammer während des den Dissoziationsreaktionen des Zirconiumsalzes entsprechenden Temperaturintervalls ohne Trägergaszirkulation auf Überdruck gehalten wird.

2. Verfahren nach Anspruch 1, dessen Temperaturanstieg eine zwischen 200 °C und 700 °C, insbesondere zwischen 300 °C und 600 °C umfasste Stufe umfasst.

3. Verfahren nach Anspruch 2, wobei die Dauer der Heizstufe 5 bis 30 Minuten beträgt.

4. Verfahren nach einem der vorstehenden Ansprüche, wobei das Trägergas zur Zirkulation durch die Kammer gebracht wird, nachdem die Temperatur der Kammer das Temperaturintervall überschritten hat.

5. Verfahren nach einem der vorstehenden Ansprüche, wobei schrittweise bei einer Temperaturanstiegsgeschwindigkeit im Bereich zwischen 4 und 20 °C pro Minute erwärmt wird.

6. Verfahren nach einem der vorstehenden Ansprüche, wobei der Aktivator weiter mindestens ein Ammoniumhalogenid enthält.

7. Verfahren nach einem der vorstehenden Ansprüche, dessen Trägergas ein Reduktionsgas, wie H2, oder neutral, wie Argon, ist.

8. Verfahren nach dem vorstehenden Anspruch, wobei das Teil aus einer nickelbasierten Superlegierung besteht.

9. Verfahren nach einem der vorstehenden Ansprüche, wobei das Element Zirconium mindestens teilweise durch Hafnium oder Yttrium ersetzt wird.

10. Verfahren nach einem der vorstehenden Ansprüche, wobei die Behandlungstemperatur im Bereich zwischen 950 und 1.200 °C, und vorzugsweise bei etwa 1.100 °C liegt.

## Claims

1. A process for forming a protective coating containing aluminum and aluminum on the surface of a metal part, wherein
said part and a cement made of aluminum alloy are brought into contact with a gas at a treatment temperature in a treatment chamber,
the gas comprising a carrier gas and an activator,
the activator reacting with the cement to form a gaseous aluminum halide, which decomposes at the surface of the part depositing metallic aluminum thereon,
the activator containing a zirconium salt, such as ZrO(¾ obtained from zirconium salt granules, the dissociation reactions of said zirconium salt taking place in a dissociation temperature interval with formation of a deposit of Zr metal at the surface of the part,
the part, the cement and the zirconium salt granules are gradually heated together in the chamber from ambient temperature up to the treatment temperature, **characterized in that** the treatment chamber is maintained at an overpressure without circulation of carrier gas over the temperature interval corresponding to the dissociation reactions of the zirconium salt.

2. The process as claimed in claim 1, wherein the temperature rise comprises a hold between 200°C and 700°C, more particularly between 300°C and 600°C.

3. The process as claimed in claim 2, wherein the duration of the heating hold is from 5 to 30 minutes.

4. The process as claimed in one of the preceding claims, wherein the carrier gas is circulated through the chamber after the temperature of the chamber has exceeded said temperature interval.

5. The process as claimed in one of the preceding claims, wherein the heating is carried out gradually at a temperature rise rate of between 4°C and 20°C per minute.

6. The process as claimed in one of the preceding claims, wherein said activator additionally contains at least one ammonium halide.

7. The process as claimed in one of the preceding claims, wherein the carrier gas is a reducing gas, such as H₂, or neutral gas, such as argon.

8. The process as claimed in the preceding claim, wherein the part is made of a superalloy based on nickel.

9. The process as claimed in one of the preceding claims, wherein the zirconium element is at least partly replaced by hafnium or yttrium.

10. The process as claimed in one of the preceding claims, wherein said treatment temperature is between 950 and 1200°C and preferably approximately 1100°C
